# EUROPÄISCHE PATENTSCHRIFT

(11) **EP 1 720 250 B1**
(45) Veröffentlichungstag und Bekanntmachung des Hinweises auf die Patenterteilung: **13.04.2011**
(21) Anmeldenummer: 06003241.4
(22) Anmeldetag: 17.02.2006
(51) Int. Cl.: H03H 7/01

(54) **Koppelkondensator-Anordnung**
Coupling capacitor device
Dispositif de condensateur de liaison

(30) Priorität: 28.04.2005 DE 102005019838
(43) Veröffentlichungstag der Anmeldung: 08.11.2006
(73) Patentinhaber: Rohde & Schwarz GmbH & Co. KG, 81671 München (DE)
(72) Erfinder: Richt, Bernhard, 81827 München (DE)
(74) Vertreter: Körfer, Thomas

(56) Entgegenhaltungen:
- US-A- 4 945 317
- US-A- 5 233 310
- US-A- 5 352 994

## Beschreibung

Die Erfindung betrifft eine Koppelkondensator-Anordnung zur gleichspannungsgetrennten Verbindung von Hochfrequenz-Schaltungen.

Zur Gleichspannungstrennung von Hochfrequenz-Schaltungen, zwischen denen eine Hochfrequenzverbindung beispielsweise zur Signalübertragung erforderlich ist, werden Koppelkondensatoren benutzt, die so dimensioniert sind, dass die Signalübertragung zwischen den Hochfrequenzschaltungen im Übertragungsfrequenzbereich (Niederfrequenz- bis Mikrowellen-Bereich) möglichst nicht beeinträchtigt wird. Die untere Frequenzgrenze des Übertragungsfrequenzbereiches wird durch die Größe der Kapazität des Koppelkondensators bestimmt. Die obere Frequenzgrenze hängt wesentlich von der wellenwiderstandsrichtigen Auslegung des Koppelkondensators ab. Bei höheren Frequenzen im Mikrowellenbereich wird die obere Frequenzgrenze deshalb mitbestimmt durch die Größe (Volumen) des Koppelkondensators. Koppelkondensatoren, die in einem großen Frequenzbereich von nur einigen kHz bis mehreren GHz benutzt werden sollen, müssen einerseits für die tiefen Frequenzen eine relativ hohe Kapazität aufweisen, sollen andererseits jedoch für hohe Frequenzen ein möglichst kleines Volumen besitzen. Außerdem wird meist noch gefordert, dass der Koppelkondensator eine möglichst hohe Gleichspannungsfestigkeit besitzt. Diese drei Eigenschaften können mit üblichen Koppelkondensatoren nur schwer erreicht werden.

Es ist daher Aufgabe der Erfindung, eine Koppelkondensator-Anordnung aufzuzeigen, die hohe Gleichspannungsfestigkeit aufweist und für niedere Frequenzen die gewünschte hohe Kapazität und die trotzdem die für hohe Frequenzen gewünschten kleinen Abmessungen (Volumen) besitzt.

Diese Aufgabe wird ausgehend von einer Koppelkondensator-Anordnung laut Oberbegriff des Hauptanspruches durch dessen kennzeichnende Merkmale gelöst. Vorteilhafte Weiterbildungen ergeben sich aus den Unteransprüchen.

Gemäß der Erfindung werden mehrere einzelne Koppelkondensatoren für Gleichspannung parallel geschaltet und zwar jeweils auf der einen, dem Eingang zugewandten Seite und der dem Ausgang zugewandten anderen Seite der Koppelkondensatoren durch die in Reihe geschalteten Kompensations-Induktivitäten LK bzw. L, die bei höheren Frequenzen zusammen mit den Streukapazitäten der Koppelkondensatoren gegen Masse Tiefpässe bilden und so die obere Grenzfrequenz der Anordnung bestimmen, bei welcher eine bestimmte Fehlanpassung des Wellenwiderstandes erreicht wird. Die Anordnung besitzt also für niedere Frequenzen beispielsweise im kHz-Bereich Hochpasseigenschaften, bei hohen Frequenzen beispielsweise im GHz-Bereich Tiefpass-Eigenschaften.

Die Größe der benutzten Kompensations-Induktivitäten hängt von der Art der verwendeten Koppelkondensatoren und den dadurch bedingten Streukapazitäten der Koppelkondensatoren gegen Masse ab. Der durch die Kompensations-Induktivitäten mit den zugehörigen Streukapazitäten des Koppelkondensators gebildete Tiefpass wird für die gewünschte obere Grenzfrequenz berechnet, bei welcher die zulässige Fehlanpassung erreicht wird. Dies kann mit üblichen Simulationsprogrammen berechnet werden.

Die erfindungsgemäße Koppelkondensator-Anordnung ermöglicht es, dass durch Parallelschaltung von entsprechend vielen einzelnen Koppelkondensatoren, von denen jeder möglichst kleine räumliche Abmessung und die erforderliche Gleichspannungsfestigkeit besitzt, die erforderliche große Koppel-Kapazität für den unteren Frequenzbereich erreicht wird. Damit werden also die eingangs geforderten drei wesentlichen Eigenschaften eines Koppelkondensators auf einfache Weise erreicht.

Besonders vorteilhaft ist es, die Kompensations-Induktivitäten als Hochfrequenzleitungen auszubilden, wofür die verschiedenartigsten technischen Formen wie Koaxialleitungen, Stripline-, Mikrostrip-, oder Koplanar-Leitungen geeignet sind. Um das induktive Verhalten zu erreichen, werden diese Hochfrequenzleitungen gegenüber dem Systemwellenwiderstand (im Allgemeinen 50 Ohm) hochohmig ausgebildet. Als Koppelkondensatoren sind alle üblichen Kondensator-Bauelemente geeignet, als besonders vorteilhaft haben sich jedoch sog. Chip-Kondensatoren erwiesen, die auf einer geeigneten Mikrostrip-Leitung angeordnet werden. Solche Chip-Kondensatoren sind bauartbedingt besonders gut bis zu sehr hohen Frequenzen geeignet, da die durch die räumliche Ausdehnung unvermeidliche Serien-Induktivität des Kondensators gering ist. Die Anschlussflächen bestimmen die Streukapazitäten des Koppelkondensators gegen Masse, die gemäß der Erfindung durch die Kompensations-Induktivitäten kompensiert werden. Als besonders vorteilhaft hat es sich erwiesen, sämtliche parallel geschalteten Koppelkondensatoren gleich groß zu wählen, da störende Resonanzen mit den Serien-Induktivitäten der Koppelkondensatoren vermieden werden.

Die Erfindung wird im Folgenden anhand schematischer Zeichnungen an einem Ausführungsbeispiel näher erläutert.
- Fig. 1: zeigt das Prinzipschaltbild einer erfindungsgemäßen Koppelkondensator-Anordnung,
- Fig. 2: zeigt eine praktische Realisierung in Mikrostrip-Technik unter Verwendung von Chip-Kondensatoren.

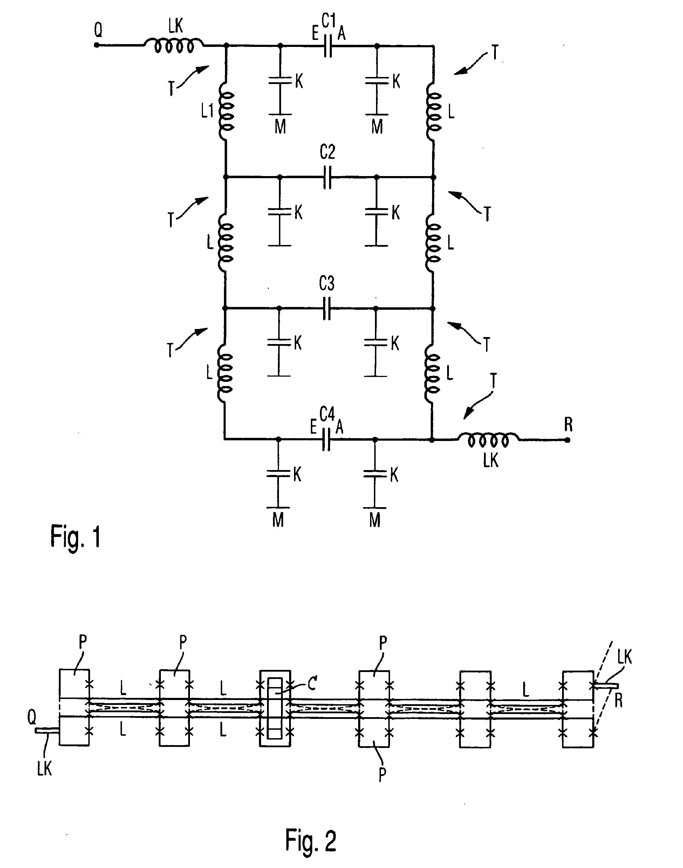

Die in Fig. 1 dargestellte erfindungsgemäße Koppelkondensator-Anordnung besteht aus mehreren im Ausführungsbeispiel vier Koppelkondensatoren C, die für Gleichstrom elektrisch gesehen parallel geschaltet sind.

Dies wird dadurch erreicht, dass jeweils die Eingänge E der Koppelkondensatoren durch eine erste Reihe von hintereinander angeordneten Kompensations-Induktivitäten L miteinander verbunden sind, ebenso die Ausgänge A der Koppelkondensatoren durch eine zweite Reihe entsprechender Kompensations-Induktivitäten L. Der Ausgang Q der einen der beiden miteinander zu verbindenden nicht dargestellten Hochfrequenz-Schaltungen ist ebenfalls über eine entsprechende Kompensations-Induktivität LK mit dem Verbindungspunkt zwischen dem Eingang E des ersten Koppelkondensators C1 der Reihe und der diesen ersten Koppelkondensator C1 mit dem zweiten Koppelkondensator C2 verbindenden Kompensations-Induktivität L1 verbunden. Ebenso ist zwischen dem Ausgang A des letzten Koppelkondensators C4 der Reihe und dem Anschluss R der anderen ebenfalls nicht dargestellten Hochfrequenzschaltung eine zusätzliche Kompensationsinduktivität LK angeordnet.

Die Anschlüsse E und A der Koppelkondensatoren bilden je nach ihren räumlichen Abmessungen und der Größe der Anschlusspads P mehr oder weniger große Streukapazitäten K jeweils gegen Masse M, die jedoch durch die Kompensations-Induktivitäten L bzw. LK kompensiert werden. Die Streukapazitäten K bilden mit den Kompensations-Induktivitäten L bzw. LK jeweils Tiefpässe T. Die Gesamtanordnung besteht also aus einer Kette von Tiefpässen T jeweils auf beiden Seiten E und A der eigentlichen Koppelkondensatoren C. Für hohe Frequenzen stellen die Koppelkondensatoren C einen Kurzschluss dar, durch welchen die beiden Tiefpassketten miteinander verbunden sind. Für extrem hohe Frequenzen wird diese Verbindung durch die unvermeidliche Serien-Induktivität der Koppelkondensatoren C hergestellt. Die Kompensations-Induktivitäten L der beiden parallelen Tiefpassketten sind vorzugsweise je paarweise miteinander gekoppelt und bilden daher für hohe Frequenzen einen Leitungskoppler.

Die Berechnung der die Tiefpässe T bildenden Kompensations-Induktivitäten L bzw. LK erfolgt vorzugsweise mit einem üblichen Computer-Simulationsprogramm. Vorgegeben ist dabei die Größe der Streukapazitäten K der Koppelkondensatoren gegen Masse, die bestimmt wird durch die Art des verwendeten Koppelkondensators und seiner Anordnung in der Schaltung. Die Größe der Kompensations-Induktivitäten L bzw. LK der Tiefpässe und die Größe der Anschlusspads P wird bezüglich der gewünschten oberen Grenzfrequenz bemessen, bei welcher eine vorbestimmte Fehlanpassung auftritt.

Die Kompensations-Induktivitäten L werden vorzugsweise als paarweise gekoppelte Hochfrequenzleitungen ausgebildet, beispielsweise als induktiv wirkende, gegenüber dem Systemwellenwiderstand von beispielsweise 50 Ohm hochohmige Mikrostrip-Leitungen mit geringer Leitungsbreite, wie dies Fig. 2 in Draufsicht auf eine übliche Mikrostrip-Substratanordnung zeigt. Die miteinander gekoppelten und die Kompensations-Induktivitäten bildenden Mikrostrip-Leitungen L verbinden jeweils die Anschlusspads P für die in diesem Beispiel sechs Koppelkondensatoren C, die in diesem Beispiel als Chip-Kondensatoren ausgebildet und jeweils zwischen diesen Anschlusspads P befestigt sind, wie dies für einen Koppelkondensator C in Fig. 2 schematisch angedeutet ist.

Die Anschlusspads der Chip-Kondensatoren sind beispielsweise mit den Anschlusspads P der Mikrostripleitung verlötet. Für einen hohen Wellenwiderstand der Kompensations-Leitungen L ist es vorteilhaft, den Abstand zwischen den gegenüberliegenden Kompensationsleitungen L möglichst gering zu wählen, um so eine möglichst starke Kopplung zwischen diesen Leitungen zu erreichen. Um die räumliche Ausdehnung zu minimieren, können die Leitungsabschnitte L zwischen den einzelnen Anschlusspads P auch entsprechend gefaltet, beispielsweise in Mäanderform ausgeführt werden, wobei lediglich darauf zu achten ist, dass die Länge der Leitungen gleich bleibt.

Auch diese Dimensionierung der Leitungen für die gewünschte Größe der Induktivität L erfolgt in bekannter Weise durch ein entsprechendes Simulationsprogramm. Als besonders vorteilhaft hat es sich erwiesen, jeweils gleichgroße Koppelkondensatoren C zu benutzen, da es sich herausgestellt hat, dass dann störende Resonanzen vermieden werden.

Die Erfindung ist nicht auf das dargestellte Ausführungsbeispiel beschränkt. Sämtliche beschriebenen oder gezeichneten Elemente sind im Rahmen der Erfindung beliebig miteinander kombinierbar. Die Erfindung ist bestimmt durch die nach die nachfolgenden Ansprüche.

## Patentansprüche

1. Koppelkondensator-Anordnung zur gleichspannungsgetrennten Verbindung von Hochfrequenz-Schaltungen,
wobei mehrere jeweils ein- und ausgangsseitig (E, A) über hintereinander angeordnete und in Reihe geschaltete Kompensations-Induktivitäten (L) parallel geschaltete Koppel-Kondensatoren (C) vorgesehen sind und vor dem Eingang (E) des ersten Koppelkondensators (C1) der eingangsseitigen Kompensations-Induktivitäts-Reihe und der einen zu verbindenden Hochfrequenz-Schaltung (Ausgang Q) sowie dem Ausgang (A) des letzten Koppel-Kondensators (C4) der ausgangsseitigen Kompensations-Induktivitäts-Reihe jeweils eine zusätzliche Koppel-Induktivität (LK) angeordnet ist,
und wobei die Kompensations-Induktivitäten (L) und/oder die Koppel-Induktivitäten (LK) so bemessen sind, dass die gegen Masse (M) wirkenden Streukapazitäten (K) der Koppel-Kondensatoren (C) kompensiert werden.

2. Anordnung nach Anspruch 1,
**dadurch gekennzeichnet,**
**dass** die Kompensations-Induktivitäten (L) der beiden an Ein- und Ausgang der Koppel-Kondensatoren (C) gegenüberliegenden Reihen miteinander gekoppelt sind.

3. Anordnung nach Anspruch 1 oder 2,
**dadurch gekennzeichnet,**
**dass** die in Reihe angeordneten Kompensations-Induktivitäten (L) und/oder die Koppelinduktivitäten (LK) durch Hochfrequenz-Leitungen gebildet sind.

4. Anordnung nach Anspruch 3,
**dadurch gekennzeichnet,**
**dass** die Hochfrequenz-Leitungen gegenüber dem Systemwellenwiderstand einen hohen Wellenwiderstand besitzen.

5. Anordnung nach Anspruch 3 oder 4,
**dadurch gekennzeichnet,**
**dass** die Hochfrequenz-Leitungen als im geringen Abstand nebeneinander parallel angeordnete Mikrostrip-Leitungen ausgebildet sind.

6. Anordnung nach einem der Ansprüche 3 bis 5,
**dadurch gekennzeichnet,**
**dass** die Koppel-Kondensatoren (C) Chip-Kondensatoren sind.

7. Anordnung nach einem der vorhergehenden Ansprüche 3 bis 6,
**dadurch gekennzeichnet,**
**dass** die Koppel-Kondensatoren (C) jeweils gleichgroße Kapazität besitzen.

8. Anordnung nach einem der vorhergehenden Ansprüche 3 bis 7,
**dadurch gekennzeichnet,**
**dass** die Hochfrequenz-Leitungen zwischen den Koppel-Kondensatoren mäanderförmig angeordnet sind.

## Claims

1. Coupling capacitor arrangement for the DC-voltage-isolated connection of radiofrequency circuits, wherein a plurality of coupling capacitors (C) are provided which are connected in parallel with one another in each case on the input and output side (E, A) via compensation inductances (L), which are arranged one behind the other and are connected in series, and in each case an additional coupling inductance (LK) is arranged upstream of the input (E) of the first coupling capacitor (C1) of the input-side compensation inductance series and one radiofrequency circuit (output Q) to be connected as well as the output (A) of the last coupling capacitor (C4) of the output-side compensation inductance series, and wherein the compensation inductances (L) and/or the coupling inductances (LK) are dimensioned in such a way as to compensate for the stray capacitances (K) of the coupling capacitors (C), which stray capacitances act with respect to earth (M).

2. Arrangement according to Claim 1, **characterized in that** the compensation inductances (L) in the two series, which are opposite one another at the input and output of the coupling capacitors (C), are coupled to one another.

3. Arrangement according to Claim 1 or 2, **characterized in that** the compensation inductances (L) arranged in series and/or the coupling inductances (LK) are formed by radiofrequency lines.

4. Arrangement according to Claim 3, **characterized in that** the radiofrequency lines have a high characteristic impedance in comparison with the system characteristic impedance.

5. Arrangement according to Claim 3 or 4, **characterized in that** the radiofrequency lines are in the form of microstrip lines arranged in parallel next to one another at a short distance from one another.

6. Arrangement according to one of Claims 3 to 5, **characterized in that** the coupling capacitors (C) are chip capacitors.

7. Arrangement according to one of the preceding claims 3 to 6, **characterized in that** the coupling capacitors (C) each have identical capacitance.

8. Arrangement according to one of the preceding claims 3 to 7, **characterized in that** the radiofrequency lines are arranged in meandering fashion between the coupling capacitors.

## Revendications

1. Dispositif de condensateur de couplage pour une liaison à tension continue distincte de commutateurs haute fréquence,
dans lequel plusieurs condensateurs de couplage (C) montés en parallèle respectivement côté entrée et côté sortie (E, A) par l'intermédiaire d'inductivités de compensation (L) disposées l'une derrière l'autre et montées en série sont prévus et une inductivité de couplage supplémentaire respective (LK) est disposée devant l'entrée (E) du premier condensateur de couplage (C1) de la série d'inductivités de compensation côté entrée et d'un commutateur haute fréquence à relier (sortie Q) ainsi qu'à la sortie (A) du dernier condensateur de couplage (C4) de la série des inductivités de compensation côté sortie,
et dans lequel les inductivités de compensation (L) et/ou les inductivités de couplage (LK) sont mesurées, de sorte que les capacités de fuite (K) agissant contre la masse (M) des condensateurs de couplage (C) sont compensées.

2. Dispositif selon la revendication 1, **caractérisé en ce que**
les inductivités de compensation (L) des deux séries en vis-à-vis à l'entrée et à la sortie des condensateurs de couplage (C) sont couplées les unes aux autres.

3. Dispositif selon la revendication 1 ou 2, **caractérisé en ce que**
les inductivités de compensation disposées en série (L) et/ou les inductivités de couplage (LK) sont formées par des lignes haute fréquence.

4. Dispositif selon la revendication 3, **caractérisé en ce que**
les lignes haute fréquence par rapport à une impédance de système possèdent une impédance élevée.

5. Dispositif selon la revendication 3 ou 4, **caractérisé en ce que**
les lignes haute fréquence sont réalisées sous la forme de lignes microstrip disposées en parallèle à proximité l'une de l'autre.

6. Dispositif selon l'une des revendications 3 à 5, **caractérisé en ce que**
les condensateurs de couplage (C) sont des condensateurs à puce.

7. Dispositif selon l'une des revendications précédentes 3 à 6, **caractérisé en ce que**
les condensateurs de couplage (C) possèdent respectivement une capacité égale.

8. Dispositif selon l'une des revendications précédentes 3 à 7, **caractérisé en ce que**
les lignes haute fréquence entre les condensateurs de couplage sont disposées sous la forme de méandres.
